# EUROPÄISCHE PATENTSCHRIFT

(11) **EP 4 562 436 B1**
(45) Veröffentlichungstag und Bekanntmachung des Hinweises auf die Patenterteilung: **02.09.2026**
(21) Anmeldenummer: 23777142.3
(22) Anmeldetag: 08.09.2023
(51) Int. Cl.: G01R 31/54, G01R 31/28, G01R 31/52, G01R 35/00, G01R 31/00

(54) **SELBSTTESTENDE MESSEINRICHTUNG**
SELF-TESTING MEASURING DEVICE
DISPOSITIF DE MESURE À AUTO-TEST

(30) Priorität: 27.09.2022 DE 102022210181
(43) Veröffentlichungstag der Anmeldung: 04.06.2025
(73) Patentinhaber: Siemens Mobility GmbH, 80997 München (DE)
(72) Erfinder: JUHASZ, György, 92358 Seubersdorf (DE); NIEMANN, Hartmut, 91056 Erlangen (DE)
(74) Vertreter: Siemens Patent Attorneys
(86) Internationale Anmeldenummer: PCT/EP2023/074700
(87) Internationale Veröffentlichungsnummer: WO 2024/068236

(56) Entgegenhaltungen:
- US-A- 3 815 013
- US-A- 4 198 595
- US-B1- 10 359 450
- US-B2- 7 791 353

## Beschreibung

Die Erfindung betrifft eine selbsttestende Messeinrichtung. Zudem betrifft die Erfindung ein Verfahren zur Selbstüberwachung einer Messeinrichtung. Außerdem betrifft die Erfindung ein Schienenfahrzeug.

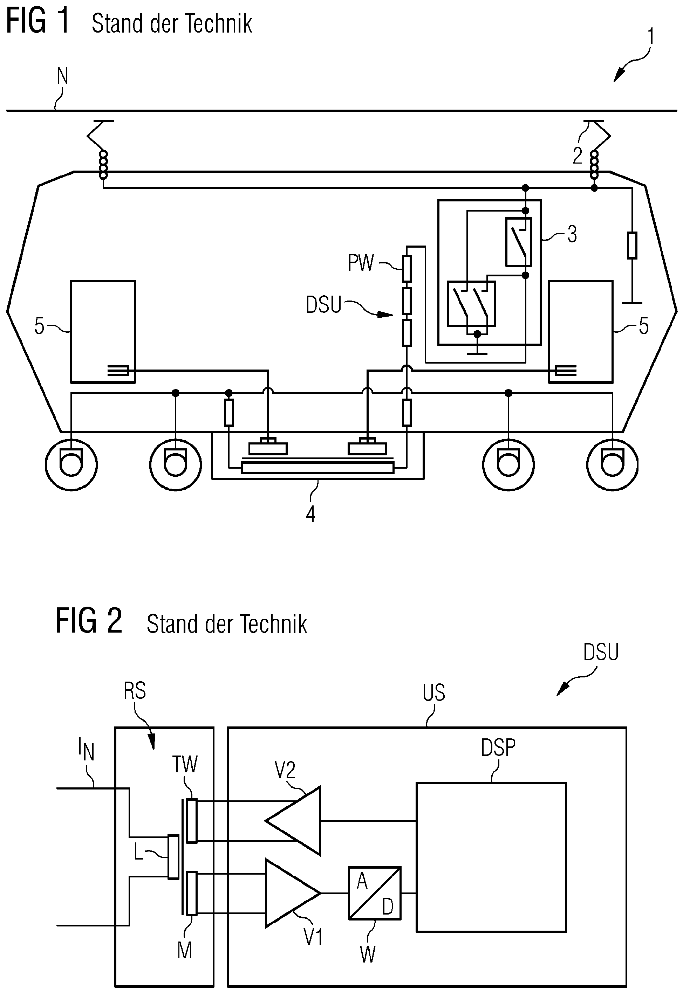

Bei dem Betrieb eines elektrischen Schienenfahrzeugs wird elektrischer Strom über einen sogenannten Oberspannungskreis zur Verfügung gestellt. Der Oberspannungskreis wird von hochgespanntem Primärstrom aus der Fahrleitung durchflossen. Dieser Primärstrom wird von einem Stromabnehmer aufgenommen und durch einen Haupttransformator auf eine niedrigere elektrische Spannung heruntertransformiert. Die niedrigere elektrische Spannung wird anschließend über einen Vierquadrantensteller in eine Zwischenkreis-Gleichspannung für einen Traktionszwischenkreis umgewandelt. Von dem Traktionszwischenkreis aus werden die Fahrmotoren, die mit Drehstrom betrieben werden, über einen Pulswechselrichter mit Drehstrom versorgt. Eine solche Anordnung ist in FIG 1 dargestellt.

In dem Oberstromkreis befindet sich auch ein Primärstromwandler, mit dem ein sehr hoher Primärstrom auf kleinere Werte reduziert wird. Der Primärstromwandler misst den Primärstrom, der über den Stromabnehmer aus dem Bahnstromnetz abgegriffen wird. Diesen Primärstrom wandelt er in einen messbaren und für normale Geräte geeigneten schwächeren Strom um. Beispielsweise wird aus 600 Ampere 1 Ampere für ein Relais bzw. Messinstrument.

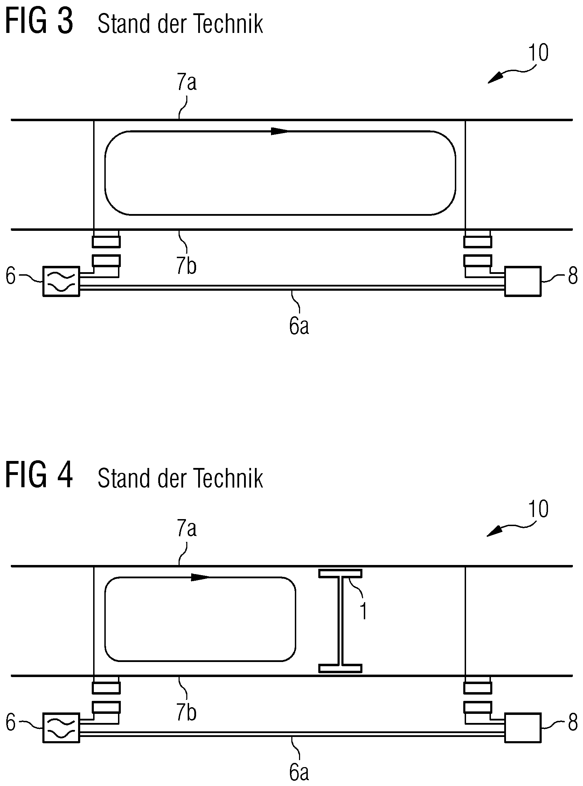

Eine sekundärseitige digitale Störstromüberwachung bzw. Strommesseinrichtung, wie sie in FIG 2 gezeigt ist, wurde bisher genutzt, um den Netzstrom eines Schienenfahrzeugs hinsichtlich niederfrequenter Wechselstromanteile zu überwachen, um eine Störung einer Überwachung eines Streckenabschnitts durch eine Gleisfreimeldeanlage im Frequenzbereich einer Gleisspannung eines Generators der Gleisfreimeldeanlage, beispielsweise in einem Frequenzbereich um eine Frequenz von 42 Hz herum, zu detektieren. Eine solche Überwachung eines Streckenabschnitts ist in FIG 3 bis FIG 5 veranschaulicht. Da die Störstromüberwachung absolut sicherheitskritisch ist, muss sie zuverlässig funktionieren. Eine Überwachung der Funktionsfähigkeit der Störstromüberwachung ist also notwendig.

Bisher erfolgte diese Selbstüberwachung durch eine Anregung einer Testwicklung eines Störstromwandlers, der der Störstromüberwachung vorgeschaltet ist, durch eine Wechselstromquelle mit einem Testsignal mit einer Testfrequenz, beispielsweise 300 Hz, wobei das Testsignal über eine Messwicklung des Störstromwandlers erfasst und von der Störstromüberwachungseinrichtung gemessen wurde. D.h. das Testsignal muss immer Bestandteil des Messsignals sein bzw. immer als Bestandteil des Messsignals gemessen werden. Wird dagegen das Testsignal nicht detektiert, so wird ein Defekt angenommen.

Für die beschriebene Selbstüberwachung sind eine Vielzahl von Bauelementen, wie zum Beispiel eine Wechselstromquelle, eine Testwicklung, eine Verstärkerschaltung und Verdrahtungen nötig.

In US 7 791 353 B2 wird ein System zur Detektion von Erdschleifen beschrieben. Das System weist einen Anreger und einen Detektor auf. Der Anreger weist einen Generator für ein Wechselstromsignal, einen Verstärker und einen Umformer auf. Der Detektor umfasst eine Rogowski-Spule, einen Filter und eine Ausleseeinheit. Die Ausleseeinheit zeigt das Auftreten einer Erdschleife in einem Leiter an, der sich zwischen dem Umformer und der Rogowski-Spule befindet.

Das Dokument US 4 198 595 A offenbart eine Messeinrichtung, die einen Sensor, einen sekundärseitigen Differenzverstärker mit einem ersten Eingang und einem zweiten Eingang, wobei der erste Eingang mit einem vorbestimmten ersten elektrischen Potential und der zweite Eingang mit einem von dem ersten elektrischen Potential unterschiedlichen vorbestimmten zweiten elektrischen Potential belegt ist, einem Ausgang, an dem ein Ausgangsspannungsoffset anliegt aufweist.

Es besteht also die Aufgabe, eine vereinfachtere Selbstüberwachung einer Messeinrichtung, insbesondere einer Störstromüberwachungseinrichtung eines elektrifizierten Schienenfahrzeugs, zu ermöglichen.

Diese Aufgabe wird durch eine selbsttestende Messeinrichtung gemäß Patentanspruch 1, ein Verfahren zur Selbstüberwachung einer Messeinrichtung gemäß Patentanspruch 8 und ein Schienenfahrzeug gemäß Patentanspruch 12 gelöst.

Die erfindungsgemäße selbsttestende Messeinrichtung, vorzugsweise eine Strommesseinrichtung, besonders bevorzugt eine Störstromüberwachungseinrichtung für einen Störstromwandler eines Schienenfahrzeugs, weist eine passive Stromwandlereinheit mit einer Primärseite und einer Sekundärseite auf.

Weiterhin weist die selbsttestende Messeinrichtung einen sekundärseitigen Differenzverstärker mit einem ersten Eingang und einem zweiten Eingang auf, dessen erster Eingang auf einem vorbestimmten ersten elektrischen Potential und dessen zweiter Eingang mit einem von dem ersten elektrischen Potential unterschiedlichen vorbestimmten zweiten elektrischen Potential, bevorzugt einem elektrischen Referenz-Potential belegt ist. Ein Differenzverstärker ist ein elektronischer Verstärker bzw. eine elektronische Verstärkerschaltung, vorzugsweise ein Operationsverstärker, mit zwei Eingängen, bei dem die Differenz der beiden Eingangssignale verstärkt wird. Der Differenzverstärker umfasst auch einen Ausgang, an dem ein Ausgangsspannungsoffset, der die Differenz zwischen den beiden Eingangssignalen, gegebenenfalls entsprechend verstärkt, widergibt, anliegt. Teil der erfindungsgemäßen selbsttestenden Messeinrichtung ist auch eine Auswertungseinheit zum Vergleichen des gemessenen Ausgangsspannungsoffsets mit einem Referenzwert. Von einem "Vergleich mit einem Referenzwert" soll auch ein Vergleich mit unterschiedlichen Referenzwertintervallen umfasst sein, die jeweils unterschiedliche Funktionszustände der Messeinrichtung, insbesondere einen fehlerfreien Betrieb und einen Defektzustand repräsentieren, umfasst sein. Durch eine Zuordnung des gemessenen Ausgangsspannungsoffsetwerts zu einem der Referenzwertintervalle kann vorteilhaft ermittelt werden, ob die Messeinrichtung korrekt funktioniert oder einen Defekt aufweist.

Wird die erfindungsgemäße Messeinrichtung als Störstromüberwachungseinrichtung für ein Schienenfahrzeug genutzt, so weist sie bevorzugt eine digitale Störstromüberwachungseinheit mit einem Frequenzfilter für ein über ein Bahnstromnetz und über eine Stromversorgungsleitung mit elektrischem Netzstrom versorgtes Schienenfahrzeug zum Messen eines möglicherweise fließenden Störstroms auf.

Teil einer solchen speziell für die Störstromüberwachung in Schienenfahrzeugen genutzten Strommesseinrichtung bzw. Störstromüberwachungseinrichtung ist bevorzugt auch eine Steuereinheit zum Ausschalten eines Hauptschalters und zum Kontaktieren der Stromversorgungsleitung und Trennen des Stromabnehmers von der Stromversorgungsleitung für den Fall, dass bei dem oben beschriebenen Vergleich zwischen dem gemessenen Ausgangsspannungsoffset mit einem Referenzwert ein Defekt ermittelt wurde. Vorteilhaft erfolgt die Überwachung der Funktion der Störstromüberwachungseinrichtung unabhängig von einem Schließen des Hauptschalters, welches erst mehrere Sekunden nach Einschalten des Schienenfahrzeugs möglich ist. Die Funktion der Störstromüberwachungseinrichtung kann also bereits vor dem Kontaktieren der Stromversorgungsleitung geprüft werden, wodurch eine erhöhte Sicherheit bei dem Betrieb eines Schienenfahrzeugs erreicht wird. Mit der erfindungsgemäßen Messeinrichtung wird eine Überwachung gemäß IEC 61508 Sicherheitsanforderungsstufe (SIL) 2 der Messeinrichtung und insbesondere der von der Messeinrichtung umfassten passiven Stromwandlereinheit ermöglicht: Die Fehlerfälle "Kurzschluss" und "Unterbrechung" werden sicher erkannt. Wird die Messeinrichtung als Störstrommesseinrichtung in einem Schienenfahrzeug genutzt, so kann die Hardware der bereits vorhandenen Störstrommesseinrichtung für den Selbsttest genutzt werden, wobei der bei einem Einschalten der Störstrommesseinrichtung gemessene Ausgangsspannungsoffset mit einem oder mehreren geeigneten Referenzwerten verglichen wird, um zu ermitteln, ob die Störstrommesseinrichtung korrekt funktioniert. Weiterhin kann aufgrund der erhöhten Verlässlichkeit des passiven Wandlers bei der üblichen redundanten Auslegung der Störstrommesseinrichtungen in Schienenfahrzeugen ein nach Stand der Technik mit zwei bevorzugt gleichen Sekundärwicklungen für Mess- und Testsignal versehener passiver Wandler für zwei Differenzverstärker anstatt einen Differenzverstärker genutzt werden. Zudem können die bei herkömmlichen Störstrommesseinrichtungen genutzte Testwicklung sowie zugehörige Leitungen und Widerstände eingespart werden. Ist der Differenzverstärker Teil einer Elektronikbaugruppe, welche üblicherweise einen Ausgang (oder mehrere Ausgänge) zur Ansteuerung einer Testwicklung aufweist, so können diese Ausgänge statt für die Testwicklung für andere Anwendungen genutzt werden, da die Testwicklung und ihre Ansteuerung aufgrund der erfindungsgemäßen internen Selbsttestfunktion der Messeinrichtung, vorzugsweise eine Störstrommesseinrichtung, nicht mehr benötigt werden.

Bei dem Verfahren zur Selbstüberwachung einer Messeinrichtung mit einer passiven Wandlereinheit mit einer Primärseite und einer Sekundärseite und einem sekundärseitigen Differenzverstärker, welcher einen ersten Eingang und einen zweiten Eingang umfasst, wobei das Verfahren bevorzugt auf eine Strommesseinrichtung als Messeinrichtung, besonders bevorzugt auf eine Störstromüberwachungseinrichtung als Strommesseinrichtung in einem Schienenfahrzeug angewendet wird, wird zunächst die Messeinrichtung eingeschaltet. Anschließend wird ein vorbestimmtes erstes elektrisches Potential an einen ersten Eingang des sekundärseitigen Differenzverstärkers der Messeinrichtung angelegt und es wird ein vorbestimmtes zweites elektrisches Potential, welches sich von dem ersten elektrischen Potential unterscheidet, an einen zweiten Eingang des sekundärseitigen Differenzverstärkers der Messeinrichtung angelegt. Es wird außerdem ein Ausgangsspannungsoffset am Ausgang des Differenzverstärkers gemessen und mit einem Referenzwert verglichen. Das erfindungsgemäße Verfahren zur Selbstüberwachung einer Messeinrichtung teilt die Vorteile der erfindungsgemäßen selbsttestenden Messeinrichtung.

Der für die Transformation des Netzstroms genutzte Wandler, vorzugsweise ein Stromwandler, welcher dem Differenzverstärker vorgeschaltet ist, umfasst besonders bevorzugt vorteilhaft eine sogenannte Rogowski-Spule, die die erfasste Messgröße, bevorzugt einen Netzstrom, mA-genau erfassen kann. Die Spule ist eisenlos und zeigt daher keine Sättigungseffekte und weist eine exzellente Linearität auf. Dieser Stromwandler ist besonders zuverlässig und für exakte Messungen geeignet. Wird die Messeinrichtung für eine Störstrommessung genutzt, so muss der Eingangsoffset (Gleichspannung) durch geeignete Frequenzfilter (Tiefpässe, Hochpässe) von den Störfrequenzen (z. B. 42 Hz) abgetrennt werden. Das Einschwingverhalten dieser für die Frequenzselektion der Störstromüberwachungseinrichtung genutzten Frequenzfilter ist für die Überwachung des Stromwandlers absolut unkritisch. Das Einschwingen dauert gewöhnlich etwa 200 bis 300 ms. Dagegen werden bei einem Start eines Schienenfahrzeugs für eine Freigabe eines Hauptschalters mindestens 3s benötigt, so dass eine mit der erfindungsgemäßen selbsttestenden Messeinrichtung ausgerüstete digitale Störstromüberwachungseinrichtung rechtzeitig einsatzbereit ist. Vorteilhaft wird also eine frühzeitige Erkennung eines Defekts eines passiven Stromwandlers erreicht. Gegebenenfalls kann die Überwachung der Messeinrichtung durch den Einsatz einer modifizierten Software ohne Modifizierung der herkömmlichen Hardware erfolgen, da eine herkömmliche Störstromüberwachungseinrichtung bereits in den meisten Schienenfahrzeugen installiert ist und für das erfindungsgemäße Verfahren, gegebenenfalls nach einer entsprechenden Modifikation, weitergenutzt werden kann.

Es soll an dieser Stelle angemerkt werden, dass das vorbeschriebene Verfahren nicht nur für transformatorische und insbesondere für auf dem Prinzip der Rogowski-Spule basierende Stromwandler eingesetzt werden kann, sondern für alle Sensoren einsetzbar ist, die so aufgebaut sind, dass eine externe Offsetspannung an ihrem Ausgang zu einem Strom durch den Sensor führt, der (a) messbar ist und (b) die Funktionsweise des Sensors nicht störend beeinflusst, insbesondere ist das Verfahren für induktive Sensoren einsetzbar.

Das erfindungsgemäße Schienenfahrzeug weist einen Stromabnehmer zum Kontaktieren des Schienenfahrzeugs mit einer Stromversorgungsleitung eines Bahnstromnetzes, einen Oberspannungskreis mit einer erfindungsgemäßen selbsttestenden Messeinrichtung, vorzugsweise einer erfindungsgemäßen Strommesseinrichtung, einen Hauptschalter zum Verbinden und Trennen des Oberspannungskreises mit bzw. von dem Bahnstromnetz sowie eine Steuereinheit zum Ansteuern des Hauptschalters in Abhängigkeit von einem Ergebnis eines Selbsttests der Strommesseinrichtung auf.

Das Schienenfahrzeug umfasst außerdem vorzugsweise auch zusätzliche Funktionselemente, insbesondere einen Haupttransformator und den erwähnten Hauptschalter zum Kontaktieren des Haupttransformators mit dem Bahnstromnetz.

Mit der bereits erwähnten Steuereinheit erfolgt ein Trennen des Haupttransformators von der Stromversorgungsleitung für den Fall, dass die erfindungsgemäße Messeinrichtung bzw. Strommesseinrichtung einen Defekt detektiert. Das erfindungsgemäße Schienenfahrzeug teilt die Vorteile der erfindungsgemäßen selbsttestenden Messeinrichtung.

Eine typische Fehlerreaktion ist das Öffnen des Hauptschalters, der Stromabnehmer wird nur automatisch gesenkt, wenn ein Defekt des Hauptschalters erkannt/vermutet wird.

Ein Teil der zuvor genannten Komponenten der erfindungsgemäßen Messeinrichtung können ganz oder teilweise in Form von Softwaremodulen in einem Prozessor eines entsprechenden Rechensystems realisiert werden, **z.B.** von einer Steuereinheit oder einem bereits vorhandenen Rechensystem eines Schienenfahrzeugs. Eine weitgehend softwaremäßige Realisierung hat den Vorteil, dass auch schon bisher verwendete Rechensysteme auf einfache Weise durch ein Software-Update nachgerüstet werden können, um auf die erfindungsgemäße Weise zu arbeiten. Insofern wird die Aufgabe auch durch ein entsprechendes Computerprogrammprodukt mit einem Computerprogramm gelöst, welches direkt in ein Rechensystem ladbar ist, mit Programmabschnitten, um die Schritte des erfindungsgemäßen Verfahrens, zumindest die durch einen Computer ausführbaren Schritte, insbesondere den Schritt der Frequenzselektion und den Schritt des Vergleichens des gemessenen Ausgangsspannungsoffsets mit einem Referenzwert, auszuführen, wenn das Programm in dem Rechensystem ausgeführt wird. Ein solches Computerprogrammprodukt kann neben dem Computerprogramm gegebenenfalls zusätzliche Bestandteile, wie z. B. eine Dokumentation, und/oder zusätzliche Komponenten, auch Hardware-Komponenten, wie z.B. Hardware-Schlüssel (Dongles etc.) zur Nutzung der Software, umfassen.

Zum Transport zum Rechensystem bzw. zur Steuereinheit und/oder zur Speicherung an oder in dem Rechensystem bzw. der Steuereinheit kann ein computerlesbares Medium, z.B. ein Memorystick, eine Festplatte oder ein sonstiger transportabler oder fest eingebauter Datenträger dienen, auf welchem die von einem Rechensystem einlesbaren und ausführbaren Programmabschnitte des Computerprogramms gespeichert sind. Das Rechensystem kann z.B. hierzu einen oder mehrere zusammenarbeitende Mikroprozessoren oder dergleichen aufweisen.

Die abhängigen Ansprüche sowie die nachfolgende Beschreibung enthalten jeweils besonders vorteilhafte Ausgestaltungen und Weiterbildungen der Erfindung. Zudem können im Rahmen der Erfindung die verschiedenen Merkmale unterschiedlicher Ausführungsbeispiele und Ansprüche auch zu neuen Ausführungsbeispielen kombiniert werden.

Bevorzugt ist die erfindungsgemäße selbsttestende Störstromüberwachungseinrichtung derart eingerichtet, dass das vorbestimmte zweite Potential niedriger als das erste Potential ist. Bei dieser Variante fließt ein elektrischer Strom von dem ersten Eingang des Differenzverstärkers über die Sekundärwicklung der passiven Stromwandlereinheit zu dem zweiten Eingang des Differenzverstärkers für den Fall, dass die passive Stromwandlereinheit korrekt funktioniert oder kurzgeschlossen ist.

Besonders bevorzugt ist das vorbestimmte zweite Potential ein Massepotential. Vorteilhaft kann das zweite Potential durch eine einfache elektrische Masseverbindung hergestellt werden.

Ebenfalls bevorzugt ist die Auswertungseinheit der erfindungsgemäßen Messeinrichtung, vorzugsweise der erfindungsgemäßen Strommesseinrichtung dazu eingerichtet, auf Basis des Vergleichs einen der folgenden Zustände der erfindungsgemäßen Messeinrichtung zu ermitteln:
- einen Kurzschluss der beiden Eingänge für den Fall, dass der Ausgangsspannungsoffset einen Wert in einem ersten vorbestimmten Wertintervall, besonders bevorzugt einen Wert von 0 mV, beträgt,
- einen fehlerfreien Betrieb für den Fall, dass der Ausgangsspannungsoffset einen Wert in einem zweiten vorbestimmten Werteintervall, welches mit dem ersten Werteintervall nicht überlappt, beträgt,
- einen Kabelbruch für den Fall, dass der Ausgangsspannungsoffset einen Wert in einem dritten vorbestimmten Werteintervall mit relativ zu dem ersten vorbestimmten Werteintervall und dem zweiten vorbestimmten Werteintervall höheren Werten, welches mit dem ersten und zweiten vorbestimmten Werteintervall nicht überlappt, beträgt.

Vorteilhaft können unterschiedliche Defekte, nämlich ein Kabelbruch oder ein Kurzschluss, voneinander unterschieden werden. Weiterhin können auch ein Kabelbruch und ein Kurzschluss von einem korrekten Funktionszustand unterschieden werden.

Das erste vorbestimmte Werteintervall umfasst bevorzugt einen Wert von 0 mV. Das zweite vorbestimmte Werteintervall liegt bevorzugt zwischen 7 und 10 mV und das dritte vorbestimmte Werteintervall liegt bevorzugt zwischen 70 und 100 mV. Vorteilhaft liegen die dem korrekten Betriebszustand und einem Kabelbruch zugeordneten Werteintervalle ausreichend auseinander, so dass die unterschiedlichen Zustände voneinander leicht unterschieden werden können.

Besonders bevorzugt umfasst die Auswertungseinheit der erfindungsgemäßen Messeinrichtung eine erste und eine zweite parallele Überwachungseinheit. Hierbei umfasst die erste parallele Überwachungseinheit bevorzugt eine erste Filterstufe, welche einen Bandpass mit einer Mittenfrequenz eines zu erwartenden Störstroms, beispielsweise 42 Hz, eine zweite Filterstufe mit einem Bandpass mit einer höheren Frequenz als der Mittenfrequenz, beispielsweise 100 Hz, und eine Stromamplituden-Zeit-Überwachungseinheit aufweist. Die beiden Filterstufen und die Stromamplituden-Zeit-Überwachungseinheit bilden die eigentliche Störstromüberwachung.

Parallel dazu umfasst die Auswertungseinheit als zweite parallele Überwachungseinheit eine zweite Überwachungseinheit, vorzugsweise mit einem Tiefpass, um den Ausgangsspannungsoffset des Differenzverstärkers der Messeinrichtung von den Wechselsignalen der detektierten Störströme im Primärstrom abzutrennen. Weiterhin umfasst die zweite Überwachungseinheit eine Vergleichseinheit für den erfindungsgemäßen Selbsttest, d.h. zum Prüfen anhand des Ausgangsspannungsoffsets, ob die Messeinrichtung defekt ist. D.h., der Ausgangsspannungsoffset wird bevorzugt darauf geprüft, ob er im Bereich "normal", im Bereich "Kurzschluss" oder im Bereich "Unterbrechung" liegt. Durch die Erweiterung der Auswertungseinheit um die zweite parallele Überwachungseinheit wird vorteilhaft eine herkömmliche Störstrommesseinrichtung um die erfindungsgemäße Selbsttestfunktion erweitert.

Die Erfindung wird im Folgenden unter Hinweis auf die beigefügten Figuren anhand von Ausführungsbeispielen noch einmal näher erläutert. Es zeigen:
FIG 1 eine schematische Darstellung eines herkömmlichen Schienenfahrzeugs,
FIG 2 eine schematische Darstellung einer herkömmlichen Störstromüberwachungseinheit,
FIG 3 eine schematische Darstellung einer Gleisstrommessung zwischen einem Generator und einem Motorrelais, FIG 4 eine schematische Darstellung einer Detektion eines Schienenfahrzeugs in einem Gleisabschnitt,
FIG 5 eine schematische Darstellung eines Szenarios, in dem durch ein Schienenfahrzeug ein Störstrom erzeugt wird,
FIG 6 eine schematische Darstellung eines Blockschaltbilds einer Störstromüberwachungseinrichtung,
FIG 7 eine schematische Darstellung einer Strommesseinrichtung gemäß einem Ausführungsbeispiel der Erfindung,
FIG 8 ein Flussdiagramm, welches ein Verfahren zur Selbstüberwachung einer Strommesseinrichtung gemäß einem Ausführungsbeispiel der Erfindung veranschaulicht,
FIG 9 eine schematische Darstellung einer Störstromüberwachungseinrichtung gemäß einem Ausführungsbeispiel der Erfindung,
FIG 10 eine schematische Darstellung eines Schienenfahrzeugs gemäß einem Ausführungsbeispiel der Erfindung,
FIG 11 eine schematische Darstellung des Zusammenwirkens der Störstromüberwachungsfunktion mit der erfindungsgemäßen Überwachung des Primärstromwandlers,
FIG 12 ein Schaubild, welches ein typisches Eingangssignal einer Störstrommesseinrichtung veranschaulicht.

In FIG 1 wird eine schematische Darstellung eines elektrifizierten Schienenfahrzeugs 1 veranschaulicht. Das elektrifizierte Schienenfahrzeug 1, in diesem Fall ein Schienenfahrzeug ausschließlich zum Betrieb mit Hochspannung in Form von Wechselspannung, umfasst zur Versorgung mit elektrischer Energie aus einem Bahnstromnetz N, in diesem Fall einem Wechselspannungsbahnstromnetz, einen Pantographen 2, der über einen Hauptschalter 3 mit einem Primärstromwandler PW elektrisch verbunden ist. Der Primärstromwandler PW wandelt den Wechselstrom in Bereichen von 100 bis 1200 A in kleinere Ströme. Dem Primärstromwandler PW ist der Störstromwandler RS einer Störstromüberwachungseinheit DSU nachgeschaltet. Eine solche Störstromüberwachungseinheit DSU misst Störströme in Bereichen von wenigen Milliampere. Der Störstromüberwachungseinheit DSU nachgeschaltet ist ein Haupttransformator 4, der die Hochspannung heruntertransformiert. Mit dem Haupttransformator 4 elektrisch verbunden sind zwei Stromrichter 5, die den Wechselstrom über einen Gleichspannungs-Zwischenkreis in Drehstrom für die Fahrmotoren umwandeln.

In FIG 2 ist die in FIG 1 gezeigte Störstromüberwachungseinheit DSU eines Schienenfahrzeugs 1 mit einer Rogowski-Spule RS und einer Überwachungsschaltung US grob schematisch gezeigt. Die Rogowski-Spule RS umfasst auf der Primärseite einen stromdurchflossenen Leiter L, durch den ein Netzstrom I_{N} fließt, und auf der Sekundärseite Spulenwicklungen in Form von Luftspulenwicklungen TW, M. Eine erste Luftspulenwicklung der Spulenwicklungen umfasst eine Messwicklung M (in FIG 2 unten gezeigt) und eine zweite Luftspulenwicklung der Spulenwicklungen umfasst eine Testwicklung TW (in FIG 2 oben gezeigt).

Die Überwachungsschaltung US ist auf der Sekundärseite an die beiden Spulenwicklungen TW, M angeschlossen und umfasst eine Messverstärkerschaltung V1, eine Testverstärkerschaltung V2, einen A/D-Wandler W und einen digitalen Signalprozessor DSP. Die Messwicklung M ist an die Messverstärkerschaltung V1 angeschlossen, deren Ausgang über den A/D-Wandler W an den digitalen Signalprozessor DSP angeschlossen ist. Die Testwicklung TW wird von dem digitalen Signalprozessor DSP über die Verstärkerschaltung V2 angesteuert.

In FIG 3 ist eine schematische Darstellung eines unbelegten Streckenabschnitts 10 mit einer Streckenüberwachung mit einer Gleisstrommessung zwischen einem Generator 6 (links unten im Bild) und einem Motorrelais 8 (rechts unten im Bild) veranschaulicht. Die Gleisstrommessung wird dafür genutzt, zu ermitteln, ob der Streckenabschnitt 10 frei von einem Schienenfahrzeug ist oder besetzt ist. Auf diese Weise soll ein Zusammenstoß von zwei auf demselben Gleis bzw. denselben Schienen 7a, 7b fahrenden Schienenfahrzeugen vermieden werden. Der in FIG 3 auf der linken Seite unten dargestellte Generator 6 erzeugt zwei um 90° phasenverschobene elektrische Spannungen, von denen die eine zwischen den Schienen, d.h. der isolierten Schiene 7a (oben im Bild) und der Erdschiene 7b (zwischen Generator und isolierter Schiene gezeichnet), des Streckenabschnitts 10 und die andere leitungsgebunden über eine Stromleitung 6a zu dem Motorrelais 8, das in FIG 3 auf der rechten Seite unten dargestellt ist, geführt wird. Das Motorrelais 8 wird durch Federkraft in einer Ruhelage gehalten. Die beiden elektrischen Spannungen erzeugen ein Drehfeld und damit ein Drehmoment. Das Motorrelais 8 dreht sich daher bei einem unbelegten Streckenabschnitt 10 in die Arbeitslage und der Streckenabschnitt 10 wird als frei erkannt.

In FIG 4 ist der in FIG 3 bereits gezeigte Streckenabschnitt 10 in einer Situation gezeigt, in der sich ein Schienenfahrzeug 1 auf dem überwachten Streckenabschnitt 10 befindet. Das Schienenfahrzeug 1 schließt mit seinem Fahrgestell die zwischen den Schienen 7a, 7b anliegende Gleisspannung kurz, so dass das Drehfeld im Motorrelais 8 verschwindet. Die Feder zieht das Motorrelais 8 in die Ruhelage, der Streckenabschnitt 10 wird somit als besetzt erkannt und gemeldet.

Allerdings kann der Rückstrom eines elektrischen Schienenfahrzeugs 1 die Gleisfreimeldung stören, wenn dieser an der Messstelle gerade dem eingespeisten Strom, also dem im Fall des freien Streckenabschnitts gemessenen Strom, entspricht. Dazu muss bei der Arbeitsfrequenz des Motorrelais 8 eine Ansprechschwelle überschritten werden und diese Überschreitung muss so lange anhalten, dass das Motorrelais 8 ansprechen kann und das Ansprechen im Stellwerk (nicht gezeigt) registriert werden kann.

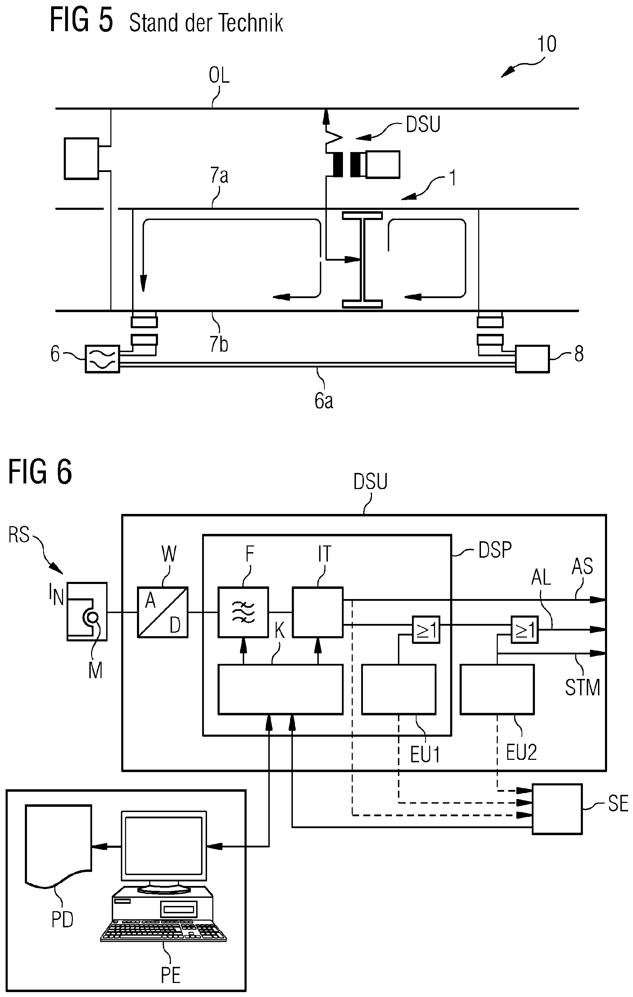

In FIG 5 ist eine schematische Darstellung eines Szenarios, in dem durch ein Schienenfahrzeug 1 ein solcher Störstrom erzeugt wird, gezeigt.

Um einen solchen sicherheitskritischen Störstrom zu vermeiden bzw. zu erkennen, weisen Schienenfahrzeuge 1 eine Störstromüberwachungseinheit DSU (in FIG 5 zwischen Oberleitung OL und Schienenfahrzeug 1 dargestellt, siehe auch Details in FIG 2) auf. Diese Störstromüberwachungseinheit DSU misst den Rückstrom und erkennt, wenn der Rückstrom gewisse Grenzwerte überschreitet. Beispielsweise darf der Rückstrom in einem vorbestimmten Frequenzbereich, in dem die Frequenz der von dem Generator 6 erzeugten elektrischen Spannung liegt, beispielsweise 42 Hz, einen vorbestimmten Grenzwert einer Stromstärke für eine Zeit, die länger als eine vorbestimmte Zeitdauer ist, nicht überschreiten, damit das Motorrelais stets korrekt arbeitet. Typische Werte sind für den Frequenzbereich 42 Hz +- 2 Hz, für den Grenzwert der Stromstärke 2,8 Ampere und für die vorbestimmte Zeitdauer 0,5 s.

In FIG 6 ist eine schematische Darstellung eines Blockschaltbilds einer Störstromüberwachungseinheit DSU eines Schienenfahrzeugs im Detail gezeigt. Wie bereits in FIG 2 gezeigt, ist die Störstromüberwachungseinheit mit einer Luftspule bzw. Messwicklung M einer Rogowski-Spule RS (oben links in FIG 6 gezeigt) elektrisch verbunden. In diesem Bild sind die Verstärkereinheiten V1 und V2 und die Testwicklung TW aus FIG 2 zur Erhöhung der Übersichtlichkeit nicht separat gezeichnet und als Teil des A/D-Wandlers W anzusehen. Der gemessene Netzstrom I_{N} des Schienenfahrzeugs 1 wird mit einem A/D-Wandler W erfasst und digitalisiert. Durch einen digitalen Signalprozessor DSP wird der gemessene Netzstrom I_{N} weiterverarbeitet und ausgewertet. Hierzu umfasst der digitale Signalprozessor DSP einen Frequenzfilter F, der die zu überwachenden Frequenzanteile aus dem Eingangssignal filtert. Weiterhin umfasst der digitale Signalprozessor eine Überwachungseinheit IT, welche die Amplitude I des Eingangssignals mit einem Stromgrenzwert und bei Überschreitung des Stromgrenzwerts die Dauer T der Überschreitung mit einem Zeitgrenzwert vergleicht. Auf eine Überschreitung der geforderten Grenzwerte wird mit einer Öffnung des Hauptschalters 3 (siehe FIG 1) reagiert.

Die Stromüberwachungseinheit DSU umfasst eine Einheit K zur Festlegung von Koeffizienten für eine Erzeugung von in ihrer Filtercharakteristik und in der Überwachungseigenschaft beliebig parametrierbaren Überwachungskanälen zur Überwachung von bis zu 5 Frequenzbändern zwischen 20 Hz und 450 Hz. Die Parametrierung des Frequenzfilters F erfolgt durch eine Parametrierdatei PD, die in einer Parametrierungseinheit PE, welche in FIG 6 durch einen Computer symbolisiert ist, abgespeichert ist. Aus der Parametrierdatei PD werden während der Fahrzeugprojektierungsphase die Filterkoeffizienten und Überwachungsparameter offline bestimmt.

Außerdem überwacht sich die Stromüberwachungseinheit DSU auch selbst. Hierzu umfasst sie eine Software-Eigenüberwachung EU1 und eine Hardware-Eigenüberwachung EU2. Im Fehlerfall erfolgt eine Hauptschalterauslösung AL sowie eine Störungsmeldung STM an die Fahrzeugsteuerung bzw. Steuerungseinheit SE des Schienenfahrzeugs. Über eine Ansprechmeldung AS kann gegebenenfalls bei einem Erreichen einer niedrigeren Schwelle durch den Störstrom, bei der die Funktion des Motorrelais noch nicht gestört ist, eine "weichere" Reaktion ausgelöst werden, wie zum Beispiel eine Drehmomentreduktion.

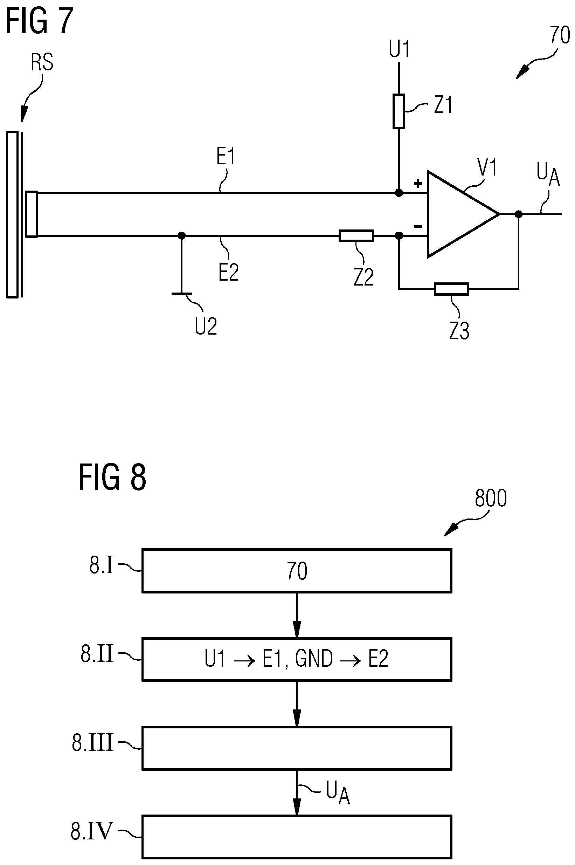

In FIG 7 ist eine schematische Darstellung einer Strommesseinrichtung 70 gemäß einem Ausführungsbeispiel der Erfindung gezeigt.

Die Strommesseinrichtung 70 weist eine passive Stromwandlereinheit RS mit einer Primärwicklung L und einer Sekundärwicklung, auch Messwicklung M genannt, und eine Messverstärkerschaltung in Form eines Differenzverstärkers V1 auf. Ein erster, nichtinvertierender Eingang E1 des Differenzverstärkers V1 ist über einen ersten komplexen Widerstand Z1 mit einem Referenzpotential U1 belegt und ein zweiter, invertierender Eingang E2 des Differenzverstärkers V1 (rückgekoppelt mit dem Ausgang des Differenzverstärkers V1 über einen zweiten komplexen Widerstand Z2 und über einen komplexen Widerstand Z3) ist mit einem zweiten Referenzpotential U2, vorzugsweise Masse GND verbunden. Aufgrund der Asymmetrie der Potentiale U1, U2 wird ein Gleichstrom verursacht, der durch die Messwicklung M der passiven Stromwandlereinheit RS fließt. Proportional zu diesem Gleichstrom wird am Ausgang des Differenzverstärkers V1 ein Spannungsoffset U_{A} gemessen. Wie bereits erwähnt, beträgt dieser Spannungsoffset U_{A} 0 Volt, wenn die passive Stromwandlereinheit RS einen Kurzschluss aufweist. Funktioniert die passive Stromwandlereinheit RS korrekt, so liegt der Wert des Spannungsoffsets U_{A} in einem mittleren Bereich. Weist die passive Stromwandlereinheit RS einen Kabelbruch auf, so liegt der Wert des Spannungsoffsets U_{A} in einem höheren Bereich. Die konkreten Wertebereiche des Spannungsoffsets U_{A} für die beschriebenen unterschiedlichen Zustände der passiven Stromwandlereinheit RS hängen auch von den Werten der komplexen Widerstände Z1, Z2, Z3 ab.

In FIG 8 ist ein Flussdiagramm 800 veranschaulicht, welches ein Verfahren zur Selbstüberwachung einer Strommesseinrichtung 70, in diesem Fall einer Störstromüberwachungseinrichtung, mit einer passiven Stromwandlereinheit RS mit einer Primärseite und einer Sekundärseite und einem sekundärseitigen Differenzverstärker V1 mit einem ersten Eingang E1 und einem zweiten Eingang E2 gemäß einem Ausführungsbeispiel der Erfindung zeigt.

Bei dem Schritt 8.I erfolgt vor dem Kontaktieren des Stromabnehmers eines Schienenfahrzeugs mit einer Oberleitung und vor einem Einschalten des Hauptschalters des Schienenfahrzeugs ein Einschalten der Störstromüberwachungseinrichtung 70. Damit kann die korrekte Funktion der Störstromüberwachungseinrichtung 70 getestet werden, bevor die Netzspannung an der Störstromüberwachungseinrichtung 70 anliegt und bei einem Defekt der Störstromüberwachungseinrichtung 70 möglicherweise bereits einen weiteren Schaden an der Elektronik hervorruft.

Bei dem Schritt 8.II erfolgt ein Anlegen eines vorbestimmten ersten elektrischen Potentials U1 an den ersten Eingang E1 des Differenzverstärkers V1 der Störstromüberwachungseinrichtung 70 und ein Anlegen eines vorbestimmten zweiten elektrischen Potentials GND, welches sich von dem ersten elektrischen Potential U1 unterscheidet, an den zweiten Eingang E2 des eingangsseitigen Differenzverstärkers V1 der Störstromüberwachungseinrichtung 70.

Bei dem Schritt 8.III wird ein Ausgangsspannungsoffset U_{A} am Ausgang des Differenzverstärkers V1 gemessen.

Bei dem Schritt 8.IV wird der Wert des gemessenen Ausgangsspannungsoffsets U_{A} mit einem Referenzwert bzw. unterschiedlichen Referenzwert-Intervallen der Störstromüberwachungseinrichtung 70, welche für unterschiedliche Zustände (Kurzschluss, korrekte Funktion, Kabelbruch) festgelegt wurden, verglichen. Wird bei dem Schritt 8.IV ein Defekt ermittelt, so kann zum Beispiel eine Meldung an den Betreiber bzw. den Fahrer des Schienenfahrzeugs übermittelt werden, ein Weiterbetrieb des Schienenfahrzeugs unterbunden werden und eine Reparatur der Störstromüberwachungseinrichtung 70 eingeleitet werden.

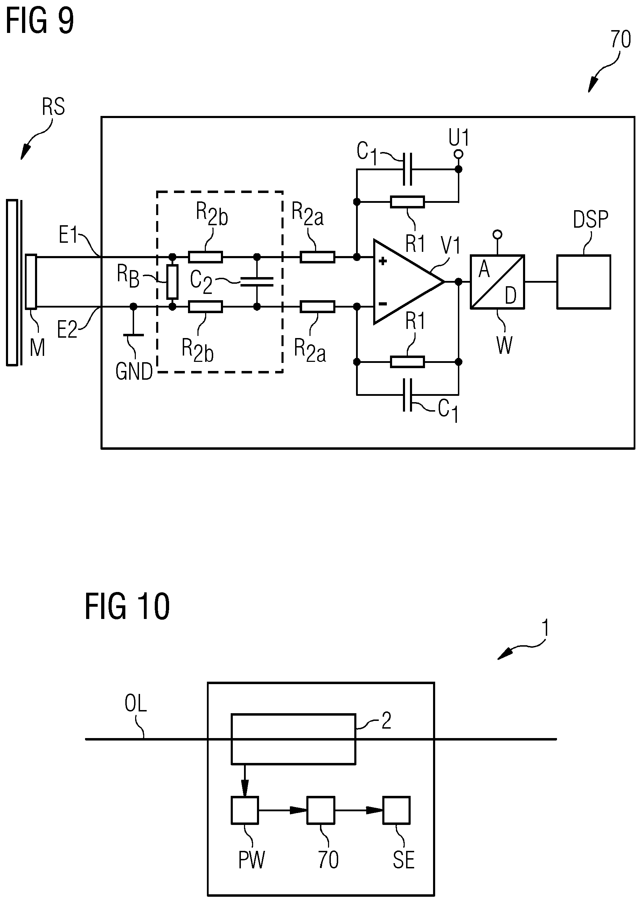

In FIG 9 ist eine schematische Darstellung einer Störstromüberwachungseinrichtung 70 gemäß einem zweiten Ausführungsbeispiel der Erfindung gezeigt. Die in FIG 9 gezeigte Anordnung entspricht im Wesentlichen der in FIG 7 gezeigten Anordnung. Es wurde lediglich statt der Grundschaltung eines nicht-invertierenden Verstärkers mit Operationsverstärker die Grundschaltung des Differenzverstärkers mit Operationsverstärker verwendet und zusätzlich zu den die Verstärkung bestimmenden Widerständen auch die zur Begrenzung der Verstärkerbandbreite üblicherweise nötigen Kapazitäten sowie ein Bürdenwiderstand R_{B} zur Anpassung an den Quellenwiderstand des Stromwandlers eingezeichnet. Das erfindungsgemäße erste Potential ist als U1 bezeichnet, das erfindungsgemäße zweite Potential U2 als GND. Ein zu der Messwicklung M des passiven Stromwandlers RS paralleler Widerstand R_{B} symbolisiert eine Bürde bzw. Last an den Eingängen des Differenzverstärkers V1. Der Bürdenwiderstand R_{B} ist niederohmig. Typische Werte für den Bürdenwiderstand liegen bei 1 bis 1000 Ohm. Die Wahl der Werte der Widerstände hängt von dem Typ des passiven Stromwandlers ab. Die Widerstände R1, R2a und R2b bestimmen die Verstärkung des Differenzverstärkers und werden so gewählt, dass der Differenzverstärker bei maximaler betrieblicher Signalamplitude eine Vollaussteuerung erfährt, aber noch nicht übersteuert. Die Kapazitäten C1 und C2 implementieren eine bei Verstärkern dieser Art übliche Bandbegrenzung zur Verhinderung hochfrequenter Schwingungen.

In FIG 10 ist eine schematische Darstellung eines Schienenfahrzeugs 1 gemäß einem Ausführungsbeispiel der Erfindung gezeigt. Das Schienenfahrzeug 1 weist einen Stromabnehmer 2 zum Kontaktieren des Schienenfahrzeugs 1 mit einer Stromversorgungsleitung OL eines Bahnstromnetzes auf.

Das Schienenfahrzeug 1 weist außerdem einen Oberspannungskreis mit einer Primärstromwandlereinheit PW und einer erfindungsgemäßen selbsttestenden Strommesseinrichtung 70, wie sie in FIG 7 und FIG 9 im Detail dargestellt ist, auf. Teil des Schienenfahrzeugs 1 ist auch eine Steuereinheit SE zum Ansteuern des Stromabnehmers 2 in Abhängigkeit von einem Ergebnis eines Selbsttests der Strommesseinrichtung 70.

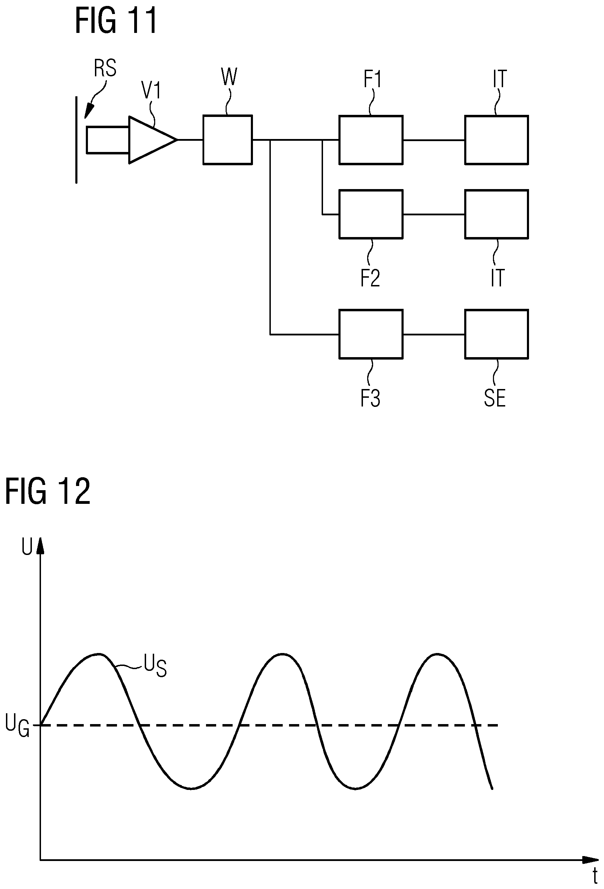

FIG 11 umfasst eine schematische Darstellung des Zusammenwirkens der Störstromüberwachungsfunktion mit der erfindungsgemäßen Überwachung des Primärstromwandlers.

In FIG 11 wird dargestellt, wie eine Störstromüberwachungseinheit DSU gemäß FIG 6 um die erfindungsgemäße Überwachung erweitert werden kann. Das Signal des Primärstromwandlers (Rogowski-Spule RS) wird mit dem Verstärker V1 verstärkt, der gemäß FIG 9 ausgeführt ist, und mit dem Analog-Digitalwandler W digitalisiert. Anschließend wird das Signal auf die parallelen Überwachungseinheiten verteilt. Beispielsweise für das Eisenbahnnetz der DB (Deutsche Bahn) ist die Filterstufe F1 ein Bandpass mit Mittenfrequenz 42 Hz, F2 ein Bandpass mit 100 Hz, diese beiden Bandpässe zusammen mit den Stromamplituden-Zeit-Überwachungseinheiten IT bilden die eigentliche Störstromüberwachung. Parallel dazu wird ein Tiefpass F3 verwendet, um den Ausgangsoffset des Verstärkers V1 von den Wechselsignalen der detektierten Störströme im Primärstrom abzutrennen, und die Steuerungseinheit SE kann die Prüfung durchführen, ob der Ausgangsoffset im Bereich "normal", im Bereich "Kurzschluss" oder im Bereich "Unterbrechung" liegt.

In FIG 12 ist ein Schaubild gezeigt, welches ein typisches Eingangssignal U_{S} einer Störstrommesseinrichtung 70 veranschaulicht. Das Eingangssignal U_{S} hat einen Gleichanteil U_{G}, der bei einer Störstrommessung durch Anwendung eines Hochpasses unterdrückt wird. Das Eingangssignal U_{S} hat auch einen Wechselanteil, der zum Beispiel mit einer Störstromfrequenz von 42 Hz schwingt und bei einer Störstrommessung ausgewertet wird. Für den erfindungsgemäßen Selbsttest dagegen wird gerade der durch die am Eingang des Differenzverstärkers V1 anliegende Offsetspannung erzeugte Gleichanteil U_{G} ermittelt. Der Gleichanteil U_{G} kann zum Beispiel durch einen Tiefpass separiert werden.

Es wird darauf hingewiesen, dass das vorbeschriebene Verfahren nicht nur, wie hier beschrieben, für transformatorische und für auf dem Prinzip der Rogowski-Spule basierende Stromwandler eingesetzt werden kann, sondern für alle Sensoren einsetzbar ist, die so aufgebaut sind, dass eine externe Offsetspannung an ihrem Ausgang zu einem Strom durch den Sensor führt, der (a) messbar ist und (b) die Funktionsweise des Sensors nicht störend beeinflusst, insbesondere für induktive Sensoren.

Es wird abschließend noch einmal darauf hingewiesen, dass es sich bei den vorbeschriebenen Verfahren und Vorrichtungen lediglich um bevorzugte Ausführungsbeispiele der Erfindung handelt und dass die Erfindung vom Fachmann variiert werden kann, ohne den Bereich der Erfindung zu verlassen, soweit er durch die Ansprüche vorgegeben ist. Es wird der Vollständigkeit halber auch darauf hingewiesen, dass die Verwendung der unbestimmten Artikel "ein" bzw. "eine" nicht ausschließt, dass die betreffenden Merkmale auch mehrfach vorhanden sein können.

## Patentansprüche

1. Selbsttestende Messeinrichtung (70), aufweisend:
- einen Sensor mit einem endlichen Quellenwiderstand und einer Sekundärseite,
- einen sekundärseitigen Differenzverstärker (V1) mit
- einem ersten Eingang (E1) und einem zweiten Eingang (E2), wobei
- der erste Eingang (E1) mit einem vorbestimmten ersten elektrischen Potential (U1) und
- der zweite Eingang (E2) mit einem von dem ersten elektrischen Potential (U1) unterschiedlichen vorbestimmten zweiten elektrischen Potential (U2) belegt ist,
- einem Ausgang, an dem ein Ausgangsspannungsoffset (U_{A}) anliegt,
**dadurch gekennzeichnet, dass** die Selbsttestende Messeinrichtung weiterhin eine Auswertungseinheit (DSP) zum Vergleichen des gemessenen Ausgangsspannungsoffsets (U_{A}) mit einem Referenzwert aufweist.

2. Selbsttestende Messeinrichtung nach Anspruch 1, wobei der Sensor eine passive Stromwandlereinheit (RS) mit einer Primär- und Sekundärseite umfasst.

3. Selbsttestende Messeinrichtung nach Anspruch 2, wobei die passive Stromwandlereinheit (RS) eine Rogowski-Spule umfasst.

4. Selbsttestende Messeinrichtung nach einem der vorstehenden Ansprüche, wobei das vorbestimmte zweite Potential (U2) niedriger als das erste Potential (U1) ist.

5. Selbsttestende Messeinrichtung nach einem der vorstehenden Ansprüche, wobei das vorbestimmte zweite Potential (U2) ein Massepotential (GND) umfasst.

6. Selbsttestende Messeinrichtung nach einem der vorstehenden Ansprüche, wobei die Auswertungseinheit (DSP) dazu eingerichtet ist, auf Basis des Vergleichs einen der folgenden Zustände der Messeinrichtung (70) zu ermitteln:
- einen Kurzschluss der beiden Eingänge (E1, E2) für den Fall, dass der Ausgangsspannungsoffset (U_{A}) einen Wert in einem vorbestimmten ersten Werteintervall beträgt,
- einen fehlerfreien Betrieb für den Fall, dass der Ausgangsspannungsoffset (U_{A}) einen Wert in einem zweiten vorbestimmten sich mit dem ersten Werteintervall nicht überlappenden Werteintervall beträgt,
- einen Kabelbruch für den Fall, dass der Ausgangsspannungsoffset (U_{A}) einen Wert in einem dritten vorbestimmten Werteintervall, welches sich mit dem ersten und zweiten vorbestimmten Werteintervall nicht überlappt, beträgt.

7. Selbsttestende Messeinrichtung nach Anspruch 6, wobei das erste vorbestimmte Werteintervall bei ca. 0 mV liegt, das zweite vorbestimmte Werteintervall zwischen 7 und 10 mV liegt und das dritte vorbestimmte Werteintervall zwischen 70 und 100 mV liegt.

8. Verfahren zur Selbstüberwachung einer Messeinrichtung (70) mit einer passiven Stromwandlereinheit (RS) mit einer Primärseite und einer Sekundärseite und einem sekundärseitigen Differenzverstärker (V1) mit einem ersten Eingang (E1) und einem zweiten Eingang (E2), aufweisend die Schritte:
- Einschalten der Messeinrichtung (70),
- Anlegen eines vorbestimmten ersten elektrischen Potentials (U1) an den ersten Eingang (E1) des Differenzverstärkers (V1) der Messeinrichtung (70),
- Anlegen eines vorbestimmten zweiten elektrischen Potentials (U2), welches sich von dem ersten elektrischen Potential (U1) unterscheidet, an den zweiten Eingang (E2) des eingangsseitigen Differenzverstärkers (V1) der Messeinrichtung (70),
- Messen eines Ausgangsspannungsoffsets (U_{A}) am Ausgang des Differenzverstärkers (V1),
**gekennzeichnet durch**:
Vergleichen des gemessenen Ausgangsspannungsoffsets (U_{A}) mit einem Referenzwert.

9. Verfahren nach Anspruch 8, wobei der Ausgangsspannungsoffset (U_{A}) über einen Tiefpass aus einem Verstärkerausgangssignal des Differenzverstärkers (V1) ermittelt wird.

10. Verfahren nach Anspruch 8 oder 9, wobei die Selbstüberwachung nach deren Einschalten vor einem Hauptschalter-EIN-Zustand gestartet wird.

11. Verfahren nach einem der Ansprüche 8 bis 10, wobei die Messeinrichtung (70) eine Störstrommesseinrichtung für ein Schienenfahrzeug umfasst.

12. Schienenfahrzeug (1), aufweisend:
- einen Stromabnehmer (2) zum Kontaktieren des Schienenfahrzeugs (1) mit einer Stromversorgungsleitung (OL) eines Bahnstromnetzes (N),
- einen Oberspannungskreis mit einer selbsttestenden Messeinrichtung (70) nach einem der Ansprüche 1 bis 7,
- einen Hauptschalter (3) zum Verbinden und Trennen des Oberspannungskreises mit bzw. von dem Bahnstromnetz (N),
- eine Steuereinheit (SE) zum Ansteuern des Hauptschalters (3) in Abhängigkeit von einem Ergebnis eines Selbsttests der Messeinrichtung (70).

13. Computerprogrammprodukt, umfassend Befehle, die bei der Ausführung des Programms durch einen Computer diesen veranlassen, die Schritte des Verfahrens zur Selbstüberwachung einer Messeinrichtung (70) nach einem der Ansprüche 8 bis 11 auszuführen.

14. Computerlesbares Speichermedium, umfassend Befehle, die bei der Ausführung durch einen Computer diesen veranlassen, die Schritte des Verfahrens zur Selbstüberwachung einer Messeinrichtung (70) nach einem der Ansprüche 8 bis 11 auszuführen.

## Claims

1. Self-testing measuring device (70) comprising:
- a sensor having a finite source resistance and a secondary side,
- a secondary-side differential amplifier (V1) having
- a first input (E1) and a second input (E2),
- the first input (E1) carrying a predetermined first electrical potential (U1) and
- the second input (E2) carrying a predetermined second electrical potential (U2), which is different from the first electrical potential (U1),
- an output to which an output voltage offset (U_{A}) is applied, **characterized in that** the self-testing measuring device additionally comprises
an evaluation unit (DSP) for comparing the measured output voltage offset (U_{A}) with a reference value.

2. Self-testing measuring device according to Claim 1, the sensor comprising a passive current transformer unit (RS) having a primary side and a secondary side.

3. Self-testing measuring device according to Claim 2, the passive current transformer unit (RS) comprising a Rogowski coil.

4. Self-testing measuring device according to one of the preceding claims, the predetermined second potential (U2) being lower than the first potential (U1).

5. Self-testing measuring device according to one of the preceding claims, the predetermined second potential (U2) comprising an earth potential (GND).

6. Self-testing measuring device according to one of the preceding claims, the evaluation unit (DSP) being configured to take the comparison as a basis for determining one of the following
states of the measuring device (70):
- a short circuit between the two inputs (E1, E2) if the output voltage offset (U_{A}) is a value in a predetermined first value range,
- correct operation if the output voltage offset (U_{A}) is a value in a second predetermined value range, which does not overlap the first value range,
- a cable fracture if the output voltage offset (U_{A}) is a value in a third predetermined value range, which does not overlap the first and second predetermined value ranges.

7. Self-testing measuring device according to Claim 6, the first predetermined value range being at approximately 0 mV, the second predetermined value range being between 7 and 10 mV, and the third predetermined value range being between 70 and 100 mV.

8. Method for self-monitoring of a measuring device (70) comprising a passive current transformer unit (RS) having a primary side and a secondary side and a secondary-side differential amplifier (V1) having a first input (E1) and a second input (E2), comprising the steps of:
- switching on the measuring device (70),
- applying a predetermined first electrical potential (U1) to the first input (E1) of the differential amplifier (V1) of the measuring device (70),
- applying a predetermined second electrical potential (U2), which differs from the first electrical potential (U1), to the second input (E2) of the input-side differential amplifier (V1) of the measuring device (70),
- measuring an output voltage offset (U_{A}) at the output of the differential amplifier (V1), **characterized by**:
- comparison of the measured output voltage offset (U_{A}) with a reference value.

9. Method according to Claim 8, wherein the output voltage offset (U_{A}) is determined from an amplifier output signal of the differential amplifier (V1) using a low-pass filter.

10. Method according to Claim 8 or 9, wherein the self-monitoring, after being switched on, is started before a main switch ON state.

11. Method according to one of Claims 8 to 10, the measuring device (70) comprising an interference current measuring device for a rail vehicle.

12. Rail vehicle (1) comprising:
- a pantograph (2) for contact-connecting the rail vehicle (1) to a power supply line (OL) of a railway power supply network (N),
- a high-voltage circuit comprising a self-testing measuring device (70) according to one of Claims 1 to 7,
- a main switch (3) for connecting and disconnecting the high-voltage circuit to and from the railway power supply network (N),
- a control unit (SE) for controlling the main switch (3) on the basis of a result of a self-test of the measuring device (70).

13. Computer program product comprising instructions that, when the program is executed by a computer, cause the computer to carry out the steps of the method for self-monitoring of a measuring device (70) according to one of Claims 8 to 11.

14. Computer-readable storage medium comprising instructions that, when executed by a computer, cause the computer to carry out the steps of the method for self-monitoring of a measuring device (70) according to one of Claims 8 to 11.

## Revendications

1. Dispositif de mesure à auto-test (70), présentant :
- un capteur avec une résistance de source finie et un côté secondaire,
- un amplificateur différentiel côté secondaire (V1) avec
- une première entrée (E1) et une seconde entrée (E2), dans lequel
- la première entrée (E1) est alimentée par un premier potentiel électrique (U1) prédéterminé et
- la seconde entrée (E2) est alimentée par un second potentiel électrique (U2) prédéterminé différent du premier potentiel électrique (U1),
- une sortie sur laquelle est appliquée un décalage de tension de sortie (U_{A}),
**caractérisé en ce que** le dispositif de mesure à auto-test présente en outre
- une unité d'évaluation (DSP) pour la comparaison du décalage de tension de sortie (U_{A}) avec une valeur de référence.

2. Dispositif de mesure à auto-test selon la revendication 1, dans lequel le capteur comprend une unité de conversion de courant passive (RS) avec un côté primaire et un côté secondaire.

3. Dispositif de mesure à auto-test selon la revendication 2, dans lequel l'unité de conversion de courant passive (RS) comprend un enroulement de Rogowski.

4. Dispositif de mesure à auto-test selon l'une des revendications précédentes, dans lequel le second potentiel (U2) prédéfini est inférieur au premier potentiel (U1).

5. Dispositif de mesure à auto-test selon l'une des revendications précédentes, dans lequel le second potentiel (U2) prédéfini comprend un potentiel de masse (GND).

6. Dispositif de mesure à auto-test selon l'une des revendications précédentes, dans lequel l'unité d'évaluation (DSP) est configurée de manière à déterminer, sur la base de la comparaison, l'un des états suivants du dispositif de mesure (70) :
- un court-circuit des deux entrées (E1, E2) dans le cas où le décalage de tension de sortie (U_{A}) atteint une valeur se situant dans un premier intervalle de valeurs prédéterminé,
- un fonctionnement sans défaillance dans le cas où le décalage de tension de sortie (U_{A}) atteint une valeur se situant dans un deuxième intervalle prédéfini qui ne chevauche pas le premier intervalle de valeurs,
- une rupture de câble dans le cas où le décalage de tension de sortie (UA) atteint une valeur se situant dans un troisième intervalle de valeurs prédéterminé, qui ne chevauche ni le premier ni le deuxième intervalle de valeurs prédéterminé.

7. Dispositif de mesure à auto-test selon la revendication 6, dans lequel le premier intervalle de valeurs prédéfini se situe à environ 0 mV, le deuxième intervalle de valeurs prédéfini se situe entre 7 et 10 mV et le troisième intervalle de valeurs prédéfini se situe entre 70 et 100 mV.

8. Procédé d'autosurveillance d'un dispositif de mesure (70) avec une unité de conversion de courant passive (RS) avec un côté primaire et un côté secondaire, et un amplificateur différentiel côté secondaire (V1) avec une première entrée (E1) et une seconde entrée (E2), présentant les étapes suivantes :
- mise en marche du dispositif de mesure (70),
- application d'un premier potentiel électrique (U1) prédéterminé à la première entrée (E1) de l'amplificateur différentiel (V1) du dispositif de mesure (70),
- application d'un second potentiel électrique (U2) prédéterminé, différent du premier potentiel électrique (U1), à la seconde entrée (E2) de l'amplificateur différentiel côté entrée (V1) du dispositif de mesure (70),
- mesure d'un décalage de tension de sortie (U_{A}) à la sortie de l'amplificateur différentiel (V1),
**caractérisé par** :
- la comparaison du décalage de tension de sortie (U_{A}) mesuré avec une valeur de référence.

9. Procédé selon la revendication 8, dans lequel le décalage de tension de sortie (U_{A}) est déterminé à l'aide d'un filtre passe-bas à partir d'un signal de sortie de l'amplificateur différentiel (V1).

10. Procédé selon la revendication 8 ou 9, dans lequel l'autosurveillance est lancée après son activation, avant qu'un état interrupteur principal Marche ne soit lancé.

11. Procédé selon l'une des revendications 8 à 10, dans lequel le dispositif de mesure (70) comprend un dispositif de mesure du courant parasite pour un véhicule ferroviaire.

12. Véhicule ferroviaire (1), présentant :
- un pantographe (2) pour la mise en contact du véhicule ferroviaire (1) avec une ligne d'alimentation électrique (OL) d'un réseau électrique ferroviaire (N),
- un circuit haute tension équipé d'un dispositif de mesure à auto-test (70) selon l'une des revendications 1 à 7,
- un interrupteur principal (3) pour la liaison du circuit haute tension avec le réseau d'alimentation ferroviaire (N) et la déconnexion du circuit haute tension du réseau d'alimentation ferroviaire (N),
- une unité de commande (SE) pour la commande de l'interrupteur principal (3) en fonction du résultat d'un auto-test du dispositif de mesure (70).

13. Produit de programme informatique, comprenant des instructions qui, lorsqu'elles sont exécutées par un ordinateur, amènent celui-ci à exécuter les étapes du procédé d'autosurveillance d'un dispositif de mesure (70) selon l'une des revendications 8 à 11.

14. Support de stockage lisible par ordinateur, comprenant des instructions qui, lorsqu'elles sont exécutées par un ordinateur, amènent celui-ci à exécuter les étapes du procédé d'autosurveillance d'un dispositif de mesure (70) selon l'une des revendications 8 à 11.
